(19) Europäisches Patentamt
European Patent Office
Office européen des brevets

(11) Numéro de publication : 0 537 240 B1

(12) **FASCICULE DE BREVET EUROPEEN**

(45) Date de publication du fascicule du brevet : **21.09.94 Bulletin 94/38**

(51) Int. Cl.$^5$ : **H01L 29/784,** H01L 29/28, H01L 29/62

(21) Numéro de dépôt : **91912389.3**

(22) Date de dépôt : **04.07.91**

(86) Numéro de dépôt international : **PCT/FR91/00541**

(87) Numéro de publication internationale : **WO 92/01313 23.01.92 Gazette 92/03**

# (54) TRANSISTORS A EFFET DE CHAMP EN COUCHE MINCE DE STRUCTURE MIS, DONT L'ISOLANT ET LE SEMICONDUCTEUR SONT REALISES EN MATERIAUX ORGANIQUES.

(30) Priorité : **04.07.90 FR 9008488**

(43) Date de publication de la demande : **21.04.93 Bulletin 93/16**

(45) Mention de la délivrance du brevet : **21.09.94 Bulletin 94/38**

(84) Etats contractants désignés : **DE FR GB IT NL**

(56) Documents cités :
**EP-A- 80 329**
**EP-A- 182 548**
**EP-A- 298 628**
**FR-A- 2 583 222**
**JP-A-58 098 909**
**SOLID STATE COMMUNICATIONS. vol. 72. No. 4, 1989. OXFORD GB pages 381 - 384; G. HOROWITZ ET AL.: "A FIELD-EFFECT TRANSISTOR BASED ON CONJUGATED ALPHA-SEXITHIENYL".**
**PATENT ABSTRACTS OF JAPAN vol. 13. No. 109 (E-727)(3457) 15 March 1989 & JP-A-63 280457**

(56) Documents cités :
**APPLIED PHYSICS LETTERS. vol. 57, NO. 19, 05 November 1990, NEW YORK US pages 2013 - 2015; x. PENG ET AL.: "ALL-ORGANIC THIN-FILM TRANSISTORS MADE OF ALPHA-SEXITHIENYL SEMICONDUCTING AND VARIOUS POLYMEICINSULATING LAYERS".**

(73) Titulaire : **CENTRE NATIONAL DE LA RECHERCHE SCIENTIFIQUE (CNRS)**
**15, Quai Anatole France**
**F-75700 Paris Cedex 07 (FR)**

(72) Inventeur : **GARNIER, Francis**
**17, villa Rémy**
**F-94500 Champigny (FR)**
Inventeur : **HOROWITZ, Gilles**
**4, place Voltaire**
**F-91140 Villebon-sur-Yvette (FR)**
Inventeur : **FICHOU, Denis**
**1, rue Delambre**
**F-75014 Paris (FR)**

(74) Mandataire : **Tonnellier, Jean-Claude**
**Cabinet Nony & Cie.**
**29, rue Cambacérès**
**F-75008 Paris (FR)**

EP 0 537 240 B1

Il est rappelé que : Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

Jouve, 18, rue Saint-Denis, 75001 PARIS

## Description

La présente invention a pour objet un transistor à effet de champ en couche mince ou TFT (thin film transistor), dans lequel les matériaux constituant le semiconducteur et l'isolant sont tous deux des matériaux organiques.

On sait que les transistors à effet de champ de structure MIS (Métal/Isolant/Semiconducteur) comportent une électrode métallique appelée grille appliquée sur une face d'une couche de matériau isolant dont l'autre face est recouverte d'une couche de matériau semiconducteur disposée entre deux électrodes d'entrée et de sortie du courant respectivement appelées source et drain. L'application d'un potentiel sur la grille crée un champ électrique faisant apparaître les charges dans le semiconducteur au voisinage de la couche isolante. On crée ainsi, dans la zone du semiconducteur situé entre la source et le drain, un pont qui peut être rendu conducteur et qui est généralement appelé "canal". Lorsque la mise sous tension de la grille rend le canal conducteur, le transistor est dit "à enrichissement", car son courant principal augmente lorsqu'on applique un potentiel sur la grille. Dans d'autres systèmes, le canal est conducteur en l'absence de tension appliquée sur la grille, et c'est l'application d'un potentiel sur la grille qui bloque le courant de canal. On dit alors qu'il s'agit d'un transistor "à appauvrissement".

Les transistors classiques à effet de champ de structure MIS, appelés couramment MISFET, sont généralement réalisés sur un support de silicium fortement dopé pour le rendre conducteur. Une couche métallique est déposée sur une face du support pour permettre d'appliquer la tension de grille. Sur l'autre face du support, on fait croître une couche isolante de silice. Sur cette couche de silice, on applique une couche semiconductrice et les deux contacts métalliques constituant la source et le drain. La source et le drain peuvent être au contact de la couche isolante ou disposés au-dessus de la couche semiconductrice.

On a proposé récemment la réalisation de transistors à effet de champ en couche mince dans lesquels le semiconducteur est une couche mince d'un polymère organique tel que le polyacétylène ; voir par exemple la demande de brevet européen 0298628. Dans les transistors de cette demande de brevet européen, la couche isolante est réalisée avec les isolants minéraux classiques (silice, nitrure de silicium) mais il est aussi envisagé d'utiliser à cet effet des polymères ayant de bonnes propriétés isolantes, sans toutefois que soit donné aucun exemple concret d'un tel isolant et d'une telle réalisation.

On sait par ailleurs que le remplacement des polymères organiques semiconducteurs par des oligomères de masse moléculaire définie permet d'améliorer la mobilité des porteurs de charges. C'est ainsi qu'on a décrit récemment un transistor en couche mince du type TFT dans lequel le semiconducteur est l'alpha-sexithiényle déposé sur un isolant constitué par de la silice. Un tel transistor a permis d'observer, sous effet de champ, une mobilité des porteurs nettement améliorée par rapport à la mobilité observée avec un dispositif comparable dont le semiconducteur est un polymère : le poly-méthylthiophène. En effet, dans le cas de l'alpha-sexithiényle, la mobilité des porteurs sous effet de champ atteint 0,84 x $10^{-3}$ $cm^2.V^{-1}.s^{-1}$. Cette valeur est dix à cent fois supérieure à celle obtenue avec des transistors comparables utilisant comme semiconducteurs des polymères organiques comme le poly(3-méthylthiophène) et le polyacétylène ; voir par exemple Horowitz G. et al., Solid State Communications, Vol.72 N° 4, pp 381-384 (1989).

On a maintenant découvert qu'il est possible d'améliorer encore la mobilité des porteurs sous effet de champ avec un transistor TFT associant un semiconduteur organique polyconjugué ayant une masse moléculaire définie (à la différence des polymères) et un polymère organique isolant convenablement choisi. L'invention permet ainsi d'améliorer les propriétés des transistors à effet de champ en couche mince. En outre, grâce à la réalisation d'un système "tout organique", il est possible de réaliser de tels transistors sur des supports de forme quelconque, y compris sur des supports souples en matériaux polymères.

La présente invention a donc pour objet un transistor à effet de champ en couche mince TFT, de structure MIS, comprenant une couche mince de semiconducteur entre une source et un drain, ladite couche mince de semiconducteur étant en contact avec une face d'une couche mince en matière isolante, et ladite couche mince isolante étant en contact par son autre face avec une grille conductrice, dans lequel ledit semiconducteur est constitué par au moins un composé organique polyconjugué ayant une masse molaire définie, caractérisé par le fait que ledit composé organique polyconjugué ou lesdits composés organiques polyconjugués contiennent un nombre de liaisons conjuguées au moins égal à 8, que ledit composé organique polyconjugué ou lesdits composés organiques polyconjugués ont une masse molaire non supérieure à 2000 environ, et que ladite couche mince de matière isolante est réalisée en polymère organique isolant possédant une constante diélectrique au moins égale à 5.

Comme cela est précisé dans la partie expérimentale ci-après, on a découvert que le pouvoir isolant n'est pas le seul critère du choix du matériau isolant et qu'il faut prendre également en considération la constante diélectrique de l'isolant. De préférence, on utilise un matériau isolant ayant une constante diélectrique au moins égale à 6. Le choix d'un tel matériau isolant influence la structure de la couche de jonction du semiconducteur,

ce qui se traduit par une amélioration de la mobilité des porteurs. Pour cette raison, on doit considérer que l'invention porte sur l'association d'un semiconducteur organique non polymère et d'un isolant polymère ayant une constante diélectrique suffisamment élevée.

Parmi les polymères isolants utilisables, on citera notamment l'alcool polyvinylique, déposé de préférence sous forme cristalline. Des résultats particulièrement intéressants sont obtenus avec une couche mince isolante constituée par le cyanoéthylpullulane. On rappelle que le cyanoéthylpullulane est un dérivé polysaccharidique obtenu par réaction du pullulane et de l'acrylonitrile en présence de catalyseur alcalin. Le cyanoéthylpullulane présente une bonne solubilité dans divers solvants organiques, et possède de bonnes propriétés adhésives sur des substrats tels que les métaux ou le verre. Le cyanoéthylpullulane, dont la préparation est décrite dans le brevet US 4,322,524, est commercialisé par la firme Shin-Etsu Chemical Co., Ltd., TOKYO (Japon).

L'utilisation, comme semiconducteurs, de composés chimiques définis, présente divers avantages (notamment de reproductibilité) par rapport à l'utilisation de polymères, qui sont en fait des mélanges de macromolécules de tailles différentes. De tels composés chimiques définis sont plus faciles à travailler que des polymères : il est généralement plus facile de les solubiliser, et il est en outre possible de les évaporer ou de les sublimer. En outre, la préparation de polymères de masses moléculaires élevées conduit à l'obtention de macromolécules présentant des défauts dont le nombre augmente avec la longueur de chaîne et qui se traduisent notamment par un abaissement de la mobilité des porteurs de charge.

Pour que le semiconducteur ait une mobilité des porteurs, sous effet de champ, suffisante, il convient qu'il possède au moins 8, et de préférence au moins 10 liaisons conjuguées (doubles liaisons et éventuellement triples liaisons).

De préférence, on choisira un semiconducteur dont la mobilité des porteurs sous effet de champ est au moins égale à $10^{-3}cm^2V^{-1}s^{-1}$, et en particulier au moins égale à $10^{-1}cm^2V^{-1}s^{-1}$.

Parmi les composés organiques polyconjugués utilisables on citera notamment les composés choisis parmi :

- des oligomères conjugués dont les motifs comprennent, ou sont constitués par, des groupements phénylène éventuellement substitués,
- des hydrocarbures polycycliques aromatiques ortho-condensés ou ortho- et péri-condensés, comportant de 4 à 20 cycles condensés,
- des polyènes de formule

  $$H\text{-} C(T_1) = C(T_2)_r \text{-}H$$

  dans laquelle $T_1$ et $T_2$ représentent indépendemment -H ou un alkyle inférieur, et r est un nombre entier pouvant varier de 8 à 50,
- des oligomères conjugués dont les motifs répétitifs contiennent au moins un hétérocycle à cinq chaînons.

Parmi les oligomères conjugués contenant des groupements phénylène, on citera notamment ceux qui répondent à la formule I :

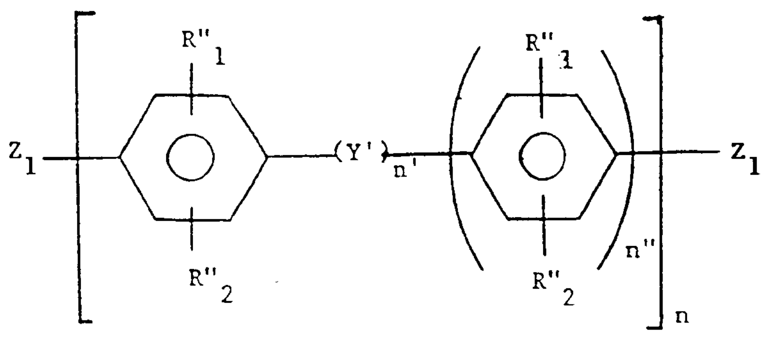

(I)

dans laquelle $R''_1$ ,$R''_2$ et $Z_1$ représentent chacun indépendamment -H, Cl, F, un groupement trifluorométhyle, un groupement nitro, Y′ représente $-C(T_1) = C(T_2)-$

-C≡C-

-N(R′)-

-N=N-

-C(R′)=N-

-N=C(R′)-,

$T_1$ et $T_2$ représentent indépendamment -H ou un alkyle inférieur,

R′ représente -H, alkyle, alkyle substitué, aryle ou aryle substitué,
n′ est un nombre égal à zéro ou 1,
n″ est un nombre égal à zéro ou 1, et
n est un nombre entier pouvant varier de 3 à 12.

Parmi les oligomères de formule I, on citera notamment ceux pour lesquels $Z_1$ = H. Lorsque le groupement $Z_1$ est différent de -H, il peut être présent sur le produit de départ ou introduit selon les méthodes connues après la réaction d'oligomérisation.

Parmi les oligomères contenant des motifs phénylène, on peut mentionner notamment les oligomères de para-polyphényle qui peuvent être préparés par exemple selon le procédé décrit par KOVACIC et KOCH, J. Org. Chem., Vol.28, pp 1864-1867 (1963).

Parmi les hydrocarbures polycycliques aromatiques condensés, on citera notamment les composés polycycliques ortho-condensés ou ortho- et péri-condensés de formule II,

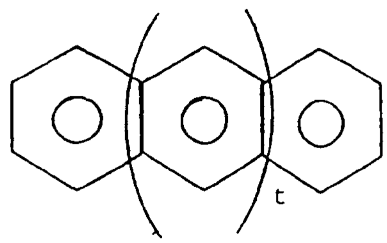

(II)

c'est-à-dire correspondant à la formule brute :

$$C_{4t+10}H_{2t+8}$$

t étant un nombre entier pouvant varier de 2 à 15.

Parmi ces composés, qui sont des composés connus, on peut citer en particulier les poly-acènes.

Les polymères ayant un nombre défini de motifs peuvent être obtenus parmi les oligomères conjugués contenant des hétérocycles à cinq chaînons, on citera en particulier ceux qui répondent à la formule III :

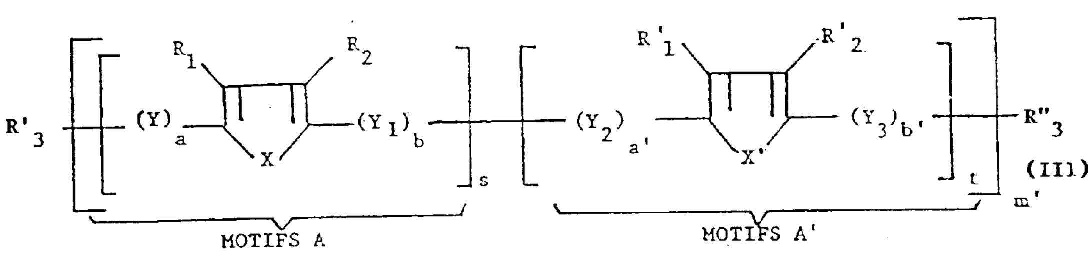

(III)

dans laquelle :

X et X′ représentent indépendamment O, S, Se, Te ou -N(R)-,

R représentant H, alkyle, alkyle substitué, aryle ou aryle substitué ;

$R_1$, $R_2$, $R'_1$,$R'_2$, $R'_3$ et $R''_3$ représentent chacun indépendamment H, Cl, F, un groupement -$CF_3$,-$NO_2$, -CN, -$COOR_3$,

-$N(R_4)(R_5)$, alkyle, alkyle substitué, aryle, aryle subsitué, alkoxy ou polyalkoxy,

$R_3$ représentant un groupement alkyle ou alkyle substitué ou un métal,

$R_4$ représentant H ou un groupement alkyle ou alkyle substitué,

$R_5$ représentant un groupement alkyle, acyle ou aryle, ou bien les couples $R_1$ et $R_2$ et/ou $R'_1$ et $R'_2$ représentent ensemble un groupement hydrocarboné divalent éventuellement insaturé ou éventuellement interrompu et/ou terminé par au moins un hétéroatome,

Y, $Y_1$, $Y_2$ et $Y_3$ représentent indépendamment un groupement :

- C(R′) = C(R″) -
- C≡ C -
- N(R′) -
- N=N -
- C(R′)=N -

- N=C(R′) -,
R′ et R″ représentant indépendamment
-H, alkyle, alkyle subsitué, aryle ou aryle substitué,
a, b, a′, b′ sont des nombres égaux à 0 ou à 1,
ou bien $Y_1$ représente en outre un groupement arylène cyclique ou hétérocyclique, et dans ce cas b = 1 et a′ = 0,
s et t sont des nombres entiers, y compris zéro, dont l'un au moins est différent de zéro,
m′ est un nombre entier au moins égal à 1,
les nombres s, t et m′ étant tels que
m′ (s + t) = m,
m étant un nombre entier de 4 à 24.

Dans l'oligomère de formule III, les motifs A et A′ peuvent être régulièrement alternés ou non. En outre, dans un même oligomère, les substituants et/ou hétéroatomes des motifs peuvent être différents.

Les oligomères hétérocycliques de formule III peuvent être préparés au départ de monomères correspondants, ou d'oligomères de rang inférieur, par des réactions de couplage oxydant, selon une méthode qui est décrite dans la demande de brevet français n° 8907610, déposé au nom du Centre National de la Recherche Scientique (C.N.R.S.) le 8 Juin 1989, intitulée "Procédé de préparation d'oligomères d'hétérocycles aromatiques par couplage oxydant d'oligomères inférieurs", et dans la demande de brevet européen n°90.401576 qui lui correspond, déposée le 8 Juin 1990. Ce procédé consiste à soumettre le produit de départ, en solution dans un solvant organique non miscible à l'eau à une réaction de couplage oxydant, à un potentiel d'oxydation inférieur à celui de la réaction de polymérisation pour obtenir un oligomère correspondant, ayant un nombre de motifs répétitifs au moins double de celui du produit de départ. La réaction de couplage oxydant peut être réalisée notamment à l'aide d'un acide de Lewis ou d'un acide de Bronsted. Parmi les acides de Lewis on peut citer $FeCl_3$, $MoCl_5$, $CuCl_2$ et $RuCl_3$. Parmi les acides de Bronsted, on peut citer les acides minéraux oxydants tels que $H_2SO_4$, $HNO_3$et $HClO_4$. La réaction de couplage oxydant peut être également effectuée par oxydation anodique dans une cellule d'électrosynthèse, en opérant dans un solvant organique contenant l'oligomère de départ et un électrolyte : par exemple, on soumet une électrode inerte, immergée dans le solvant organique contenant l'oligomère de départ et un électrolyte, sous agitation, à un potentiel anodique juste suffisant pour effectuer le couplage sans aller jusqu'à la polymérisation, et en particulier, dans le cas où l'oligomère de rang supérieur formé est insoluble dans le milieu, on opère au potentiel le plus faible pour lequel on observe une précipitation. Le solvant organique peut être choisi parmi le benzène, le chlorobenzène, le chloronaphtalène, le chlorure de méthylène, le chloroforme et le benzonitrile.

Parmi les oligomères de formule III, on citera notamment ceux pour lesquels $R'_3$ et/ou $R''_3$ représentent -H. Les groupements $R'_3$ et/ou $R''_3$ qui sont différents de -H peuvent être présents sur le monomère de départ, avant oligomérisation, ou peuvent être introduits selon les méthodes connues après oligomérisation.

Les oligomères de départ peuvent être préparés selon les méthodes connues au départ des monomères correspondants et/ou des oligomères inférieurs. Par exemple, dans le cas de dérivés du thiophène, on peut opérer selon les méthodes décrites par J.KAGAN et al.,J.Org.Chem.,48, 4317, 1983; J.KAGAN et al, Heterocycles, vol.20, n°10, 1937-1940, 1983; J.KAGAN et al, Tetrahedron Letters, vol.24, n°38, 4043-4046, 1983; J.NAKAYAMA et al., Heterocyles, vol.26, n°4, 937 (1987) et vol.27, n°7, 1731-1754, 1988; K.TAMAO et al., Tetrahedron, 38(22), 3347, 1982; S.TASAKA et al., Synth.Met., 16, 17, 1986 ; T. KAUFFMANN et al., Angew. Chem. internat. Edit-, Vol 10, N° 10,741 (1971) ; B. KRISCHE et al., J. Chem. Soc., Chem. Commun., 1476 (1987) ; D.D. CUNNINGHAM et al., J. Chem. Soc., Chem. Commun., 1021 (1987) ; R. SHABANA et al., Phosphorus, Sulfur and Silicon, Vol 48, 239-244 (1990) ; A. PELTER et al., Tetrahedron Letters, 30 , 3461 (1989). Les monomères de départ sont eux-mêmes connus ou peuvent être préparés selon les méthodes connues ; voir par exemple les demandes de brevet européen 240.063 et 257.573, le brevet US 4.731.408, la demande de brevet français 2.527.844 et M.KOBAYASHI et al, J.Chem. Phys., 82, 12, 5717-5723, 1985.

Le transistor de l'invention peut en général être préparé en utilisant des techniques connues en soi. Sur le support choisi, qui peut être par exemple un support de verre ou un polymère thermoplastique, on dépose la couche métallique constituant la grille, par exemple par pulvérisation cathodique ou par évaporation. La grille métallique peut aussi être constituée par un semiconducteur fortement dopé, ou par un conducteur organique, par exemple un polymère conducteur. On applique ensuite la couche isolante sous la forme d'une solution du polymère isolant dans un solvant organique, après quoi on évapore ou on laisse évaporer le solvant. On peut également déposer la couche isolante par évaporation ou par la technique connue dite "spin-coating". On dépose ensuite la couche semi conductrice, soit par évaporation, soit sous la forme d'une solution dans un solvant organique, ce dépôt étant suivi d'une évaporation du solvant. On peut aussi, avant de déposer le semiconducteur, modifier, de façon connue, la surface de l'isolant, par traitement mécanique (tel qu'un brossage) ou électrique (par exemple par décharge CORONA) de façon à orienter les molécules du semiconducteur à l'interface

isolant-semiconducteur. On dépose enfin, par exemple par évaporation, les électrodes métalliques constituant la source et le drain. En variante, on peut appliquer les électrodes constituant la source et le drain directement sur la couche isolante, après quoi on applique la couche de semiconducteur. La géométrie du transistor peut être toute géométrie compatible avec l'utilisation de transistor à effet de champ.

La couche isolante a généralement une épaisseur comprise entre 0,5µm et 10µm, en particulier entre 1 et 3µm. L'un des avantages de l'utilisation d'un polymère est qu'il est possible d'obtenir facilement des couches relativement épaisses, ce qui permet de diminuer les risques de claquage.

Le semiconducteur est déposé sous la forme d'une couche ayant par exemple de 20 à 200nm. Généralement, le semiconducteur est déposé sous forme neutre (non ionique) et sans dopant ajouté. On peut toutefois, si désiré, ajouter un dopant selon les techniques usuelles.

Les transistors de l'invention sont utilisables dans toutes les applications des transistors à effet de champ en couche mince, en commutation et en amplification. Cette utilisation fait partie de l'invention.

Les exemples suivants illustrent l'invention sans toutefois la limiter.

## EXEMPLE 1

On utilise comme support une plaque de verre de dimension 1 x 2,5 cm x cm. On dépose par pulvérisation une bande d'or pour former la grille. Le polymère isolant est déposé sous la forme d'une solution (1ml de solution déposé à l'aide d'une seringue de Hamilton), puis on laisse le solvant s'évaporer.

Les solvants et les concentrations de polymères utilisés sont indiqués dans le tableau (I) ci-après.

| POLYMERE | SOLVANT | CONCENTRATION(g/1) |
|---|---|---|
| CYEPL | $DMF:CH_3CN$ 1:1 (vol) | 30-60 |
| PVA | $H_2O$ | 5 |
| PVC | $DMF:CHCl_3$ | 10 |
| PMMA | $CHCl_3$ | 6 |
| PSt | $CHCl_3$ | 6 |

CYEPL : Cyanoéthylpullulane

PVA : Alcool polvinylique (Aldrich Chemie)

PVC : Chlorure de polyvinyle (Aldrich Chemie)

PMMA : Polyméthacrylate de méthyle (Aldrich Chemie)

PSt : Polystyrène (Aldrich Chemie)

L'épaisseur de la couche isolante est contrôlée par mesure de sa capacité à 10kHz entre l'électrode de grille et une électrode d'or déposée par évaporation sur la couche isolante. Sur la couche isolante, on dépose par évaporation sous vide, sous une pression de $5 \times 10^{-3}$ Pa, une couche d'alpha-sexithiényle. L'épaisseur de la couche de semiconducteur est contrôlée avec une micro-balance à quartz, en admettant une densité de 1,38 $g/cm^3$ pour l'alpha-sexithiényle. On termine la réalisation du transistor en couche mince par dépôt par évaporation de deux électrodes d'or, d'épaisseur 25nm, séparées l'une de l'autre par un espace de 90µm, ces électrodes constituant la source et le drain.

Toutes les mesures électriques ont été effectuées à l'air et à température ambiante, en utilisant des microsondes de tungstène pour les contacts électriques. Les caractéristiques courant-tension obtenues avec un pico-ampèremètre/Source de tension Hewlett Packard 4140B. La mesure de capacité a été effectuée avec un analyseur d'impédance HP 4192A. Les deux appareils étaient commandés par un micro-ordinateur HP310.

Les résultats sont résumés dans le tableau II ci-après.

TABLEAU II

| ISOLANT | $\varepsilon r$ Cte DIELEC. (à 10kHz) | MOBILITE SOUS EFFET DE CHAMP ($cm^2\ V^{-1}s^{-1}$) | TENSION (DE SEUIL) (V) | CAPACITE ($nF/cm^2$) |
|---|---|---|---|---|
| $SiO_2$ | 3,9 | $2,1x10^{-4}$ | -0,0 | 15 |
| CYEPL | 18,5 | $3,4x10^{-2}$ | -3,4 | 6 |
| PVA | 7,8 | $9,3x10^{-4}$ | -0,8 | 10 |
| PVC | 4,6 | a | a | - |
| PMMA | 3,5 | b | b | - |
| PSt | 2,6 | b | b | - |

a) Non mesurable en raison d'un effet de champ trop faible

b) Aucun effet de champ

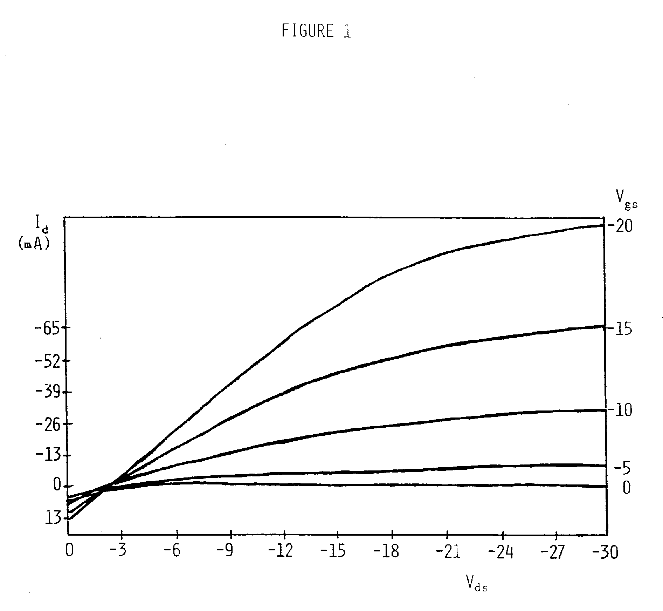

Un exemple de caractéristique d'amplification est donné dans la Fig. 1 annexée, dans laquelle on a représenté en abscisses la tension source-drain $V_{ds}$, et en ordonnées l'intensité de courant de drain ($I_d$) obtenues à différentes valeurs de la tension source-grille $V_{gs}$ (mentionnées sur la partie droite de la figure).

Il convient de remarquer que les différences de mobilité sous effet de champ, observés avec les divers solvants étudiés, ne peuvent pas être attribuées à des différences de capacité électrique du système puisque tous les dispositifs testés ont une capacité analogue, de l'ordre de $10nF/cm^2$. Le bon pouvoir isolant de la couche mince entre la grille et le semiconducteur n'est donc pas le seul critère à prendre en considération, et on a découvert que l'isolant doit avoir en outre une constante diélectrique suffisamment élevée. Bien que ces considérations ne lient pas les inventeurs et ne puissent en aucun cas être utilisées pour interpréter limitativement l'objet de la présente demande, on suppose que l'effet d'amélioration de la mobilité serait dû à une meilleure organisation structurale du semiconducteur déposé sur le substrat isolant qui est un isolant polaire, car il est connu que plus la molécule de l'isolant est polaire, plus sa constante diélectrique est élevée. Cette modification de la structure du semiconducteur au voisinage de l'isolant se traduit par une mobilité accrue des porteurs.

EXEMPLE 2

En opérant de façon analogue à celle décrite à l'exemple 1, mais en utilisant un alpha-sexithiényle purifié par extractions successives au SOXHLET par le dichlorométhane, on a obtenu les résultats suivants, résumés dans le tableau III ci-après.

Les électrodes d'or (sauce et drain) sont séparées ici par un espace de 50 µm.

TABLEAU III

| ISOLANT | MOBILITE SOUS EFFET DE CHAMP ($cm^2V^{-1}s^{-1}$) | TENSION DE SEUIL (V) |
|---|---|---|
| CYEPL | $4.10^{-1}$ | -0,8 |
| PVA | $1.10^{-3}$ | -0,8 |
| PVC | $2.10^{-5}$ | -1,0 |

## Revendications

1. Transistor à effet de champ en couche mince TFT, de structure MIS, comprenant une couche mince de semiconducteur entre une source et un drain, ladite couche mince de semiconducteur étant en contact avec une face d'une couche mince en matière isolante, et ladite couche mince isolante étant en contact par son autre face avec une grille conductrice, dans lequel ledit semiconducteur est constitué par au moins un composé organique polyconjugué ayant une masse molaire définie, caractérisé par le fait que ledit composé organique polyconjugué ou lesdits composés organiques polyconjugués contiennent un nombre de liaisons conjuguées au moins égal à 8, que ledit composé organique polyconjugué où lesdits composés organiques polyconjugués ont une masse molaire non supérieure à 2000 environ, et que ladite couche mince de matière isolante est réalisée en polymère organique isolant possédant une constante diélectrique au moins égale à 5.

2. Transistor selon la revendication 1, caractérisé par le fait que ledit polymère isolant a une constante diélectrique au moins égale à 6.

3. Transistor selon l'une quelconque des revendications précédentes, caractérisé par le fait que ledit polymère isolant est l'alcool polyvinylique.

4. Transistor selon l'une quelconque des revendications 1 à 3, caractérisé par le fait que ledit polymère isolant est le cyanoéthylpullulane.

5. Transistor selon l'une quelconque des revendications précédentes, caractérisé par le fait que ledit composé organique polyconjugué ou lesdits composés organiques polyconjugués ont un nombre de liaisons conjuguées au moins égal à 10.

6. Transistor selon l'une quelconque des revendications précédentes, caractérisé par le fait que ledit composé organique polyconjugué contient un nombre de liaisons conjuguées suffisant pour que sa mobilité sous effet de champ soit au moins égale à $10^{-3}cm^2V^{-1}s^{-1}$, et en particulier au moins égale à $10^{-1}cm^2V^{-1}s^{-1}$.

7. Transistor selon l'une quelconque des revendications précédentes, caractérisé par le fait que ledit composé organique polyconjugué est choisi parmi :
   - des oligomères conjugués dont les motifs comprennent, ou sont constitués par, des groupements phénylène éventuellement substitués,
   - des hydrocarbures polycycliques aromatiques ortho-condensés ou ortho- et péri-condensés, comportant de 4 à 20 cycles condensés,
   - les polyènes de formule

$$H\text{-} C(T_1) = C(T_2)_r \text{-}H$$

dans laquelle $T_1$ et $T_2$ représentent indépendamment -H ou un alkyle inférieur, et r est un nombre entier pouvant varier de 8 à 50,

- des oligomères conjugués dont les motifs répétitifs contiennent au moins un hétérocycle à cinq chaînons.

8. Transistor selon la revendication précédente, caractérisé par le fait que lesdits oligomères contenant des motifs phénylène répondent à la formule I :

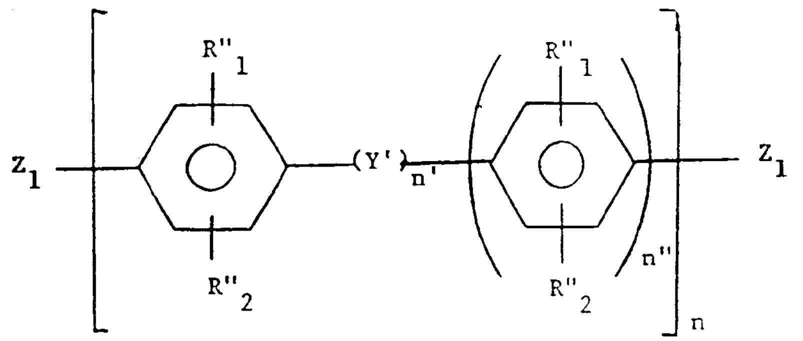

(I)

dans laquelle $R''_1$, $R''_2$ et $Z_1$ représentent chacun indépendemment -H, Cl, F, ou un groupement trifluorométhyle ou un groupement nitro, Y' représente $-C(T_1) = C(T_2)-$
$-C{\equiv}C-$
-N(R')-
-N=N-
-C(R')=N-
-N=C(R')-,
$T_1$ et $T_2$ représentent indépendemment -H ou un alkyle inférieur,
R' représente -H, alkyle, alkyle substitué, aryle ou aryle substitué,
n' est un nombre égal à zéro ou 1,
n" est un nombre égal à zéro ou 1, et
n est un nombre entier pouvant varier de 3 à 12.

9. Transistor selon la revendication précédente, caractérisé par le fait que $Z_1$ représente -H.

10. Transistor selon la revendication 7, caractérisé par le fait que ledit composé polycyclique aromatique est un composé polycyclique ortho-condensé ou ortho- et péri-condensé de formule II

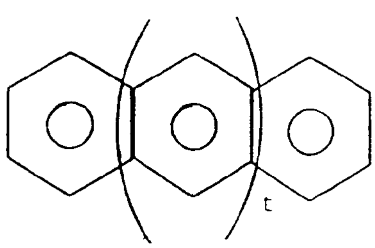

(II)

c'est-à-dire correspondant à la formule brute :

$$C_{4t+10}H_{2t+8}$$

t étant un nombre entier pouvant varier de 2 à 15.

11. Transistor selon la revendication 7, caractérisé par le fait que ledit oligomère hétérocycle aromatique est un oligomère de formule III :

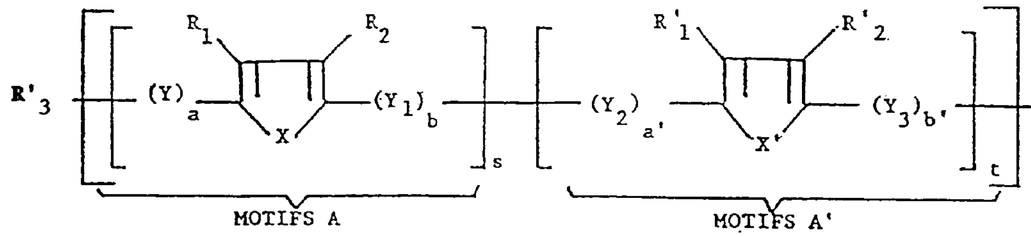


(III)

dans laquelle :

X et X′ représentent indépendamment O, S, Se, Te ou -N(R)-,

R représentant H, alkyle, alkyle substitué, aryle ou aryle substitué ;

$R_1$, $R_2$, $R'_1$, $R'_2$, et $R''_3$ représentent chacun indépendamment -H, Cl, F, un groupement $-CF_3$, $-NO_2$, -CN, $-COOR_3$,

$-N(R_4)(R_5)$, alkyle, alkyle substitué, aryle, aryle subsitué, alkoxy ou polyalkoxy,

$R_3$ représentant un groupement alkyle ou alkyle substitué ou un métal,

$R_4$ représentant H ou un groupement alkyle ou alkyle substitué,

$R_5$ représentant un groupement alkyle, acyle ou aryle, ou bien les couples $R_1$ et $R_2$ et/ou $R'_1$ et $R'_2$ et représentent ensemble un groupement hydrocarboné divalent éventuellement insaturé ou éventuellement interrompu et/ou terminé par au moins un hétéroatome,

Y, $Y_1$, $Y_2$ et $Y_3$ représentent indépendamment un groupement :

- C(R′) = C(R″) -

- C≡ C -

- N(R′) -

- N=N -

- C(R′)=N -

- N=C(R′) -,

R′ et R″ représentant indépendamment

-H, alkyle, alkyle subsitué, aryle ou aryle substitué,

a, b, a′, b′ sont des nombres égaux à 0 ou à 1,

ou bien $Y_1$ représente en outre un groupement arylène cyclique ou hétérocyclique, et dans ce cas b = 1 et a′ = 0,

s et t sont des nombres entiers, y compris zéro, dont l'un au moins est différent de zéro,

m′ est un nombre entier au moins égal à 1,

les nombres s, t et m′ étant tels que

$m'(s + t) = m$,

m étant un nombre entier de 4 à 24.

12. Transistor selon la revendication précédente, caractérisé par le fait que $R'_3$ et/ou $R''_3$ représentent -H.

13. Utilisation d'un transistor tel que défini dans l'une quelconque des revendications précédentes, comme élément de commutation ou d'amplification.

## Claims

1. Thin film field effect transistor TFT, of MIS structure, comprising a thin semiconductor film between a source and a drain, said thin semiconductor film being in contact with one face of a thin film of insulating material, and said thin insulating film being in contact, by its other face, with a conducting gate, in which said semiconductor is constituted of at least one polyconjugate organic compound having a defined molar mass, characterized by the fact that said polyconjugate organic compound or compounds contain a number of conjugate bonds at least equal to 8, that said polyconjugate organic compound or compounds have a molar mass not exceeding approximately 2,000, and that said thin film of insulating material is made of an insulating organic polymer having a dielectric constant of at least 5.

2. Transistor according to Claim 1, characterized by the fact that said insulating polymer has a dielectric constant of at least 6.

3. Transistor according to any one of the preceding Claims, characterized by the fact that said insulating polymer is polyvinyl alcohol.

4. Transistor according to any one of Claims 1 to 3, characterized by the fact that said insulating polymer is cyanoethylpullulane.

5. Transistor according to any one of the preceding Claims, characterized by the fact that said polyconjugate organic compound or compounds have a number of conjugate bonds at least equal to 10.

6. Transistor according to any one of the preceding Claims, characterized by the fact that said polyconjugate organic compound contains a number of conjugate bonds sufficient for its mobility under field effect to be at least equal to $10^{-3}cm^2V^{-1}s^{-1}$ , and in particular at least equal to $10^{-1}cm^2V^{-1}s^{-1}$.

7. Transistor according to any one of the preceding Claims, characterized by the fact that said polyconjugate organic compound is chosen from among:
   - conjugate oligomers, the motifs of which comprise, or are constituted of, possibly substituted phenylene groups,
   - aromatic polycyclic hydrocarbons, either orthocondensed or orthocondensed and pericondensed, comprising from 4 to 20 condensed cycles,
   - polyenes of the formula

     $$H\text{-}\ C(T_1) = C(T_2)_r\text{-}H$$

     where $T_1$ and $T_2$ represent independently -H or a lower alkyl, and r is a whole number which may vary from 8 to 50,
   - conjugate oligomers, the repetitive motifs of which contain at least one heterocycle having five chains.

8. Transistor according to the preceding Claim, characterized by the fact that said oligomers contain phenylene motifs complying with formula I:

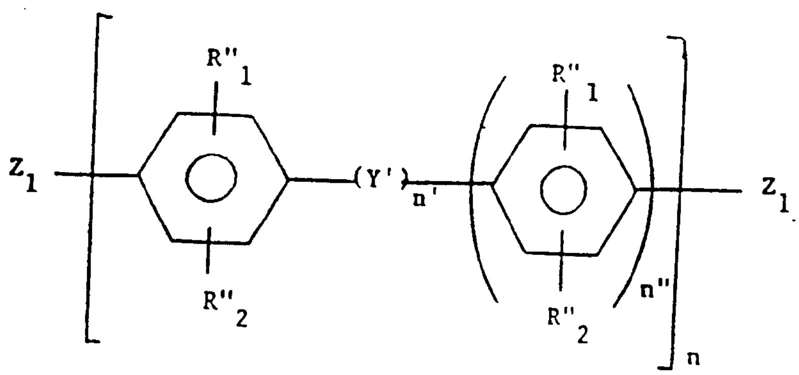

(I)

where $R''_1$, $R''_2$ and $Z_1$ each represent independently -H, Cl, F,
or a trifluoromethyl group or a nitro group,
Y′ represents $-C(T_1) = C(T_2)-$
-C≡C-
-N(R′)-
-N=N-
-C(R′)=N-
-N=C(R′ )-,
$T_1$ and $T_2$ represent independently -H or a lower alkyl,
R′ represents -H, alkyl, substituted alkyl, aryl or substituted aryl,
n′ is a number equal to zero or 1,
n″ is a number equal to zero or 1, and
n is a whole number which can vary from 3 to 12.

9. Transistor according to the preceding Claim, characterized by the fact that $Z_1$ represents -H.

10. Transistor according to Claim 7, characterized by the fact that said aromatic polycyclic compound is an orthocondensed or ortho- condensed and pericondensed polycyclic compound of formula II

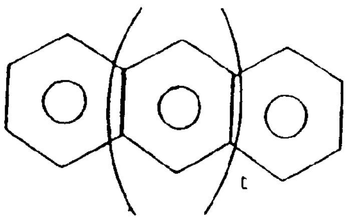

(II)

that is to say correspondign to the crude formula:

$$C_{4t+10}H_{2t+8}$$

where t is a whole number that can vary from 2 to 15.

11. Transistor according to Claim 7, characterized by the fact that said aromatic heterocyclic oligomer is an oligomer of formula III:

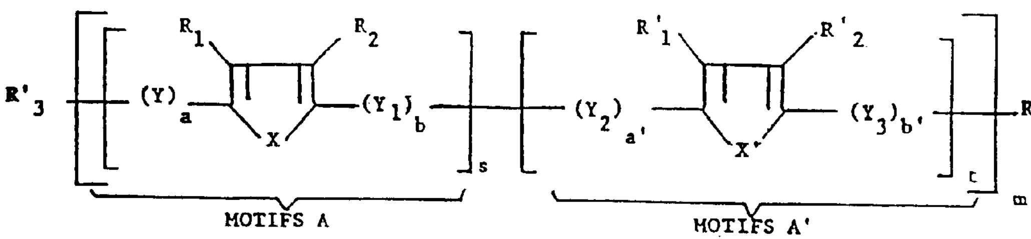

(III)

where:
X and X′ represent independently O, S, Se, Te or -N(R)-,
R representing H, alkyl, substituted alkyl, aryl or substituted aryl;
$R_1$, $R_2$, $R'_1$, $R'_2$, $R'_3$ and $R''_3$ representing each independently -H, Cl, F, a $-CF_3$, $-NO_2$, -CN, $-COOR_3$ group, $-N(R_4)(R_5)$, alkyl, substituted alkyl, aryl, substituted aryl, alcoxy or polyalcoxy group,
$R_3$ representing an alkyl or substituted alkyl group or a metal,
$R_4$ representing H or an alkyl or substituted alkyl group,
$R_5$ representing an alkyl, acyl or aryl group, or the pairs $R_1$ and $R_2$ and/or $R'_1$ and $R'_2$ represent together a bivalent hydro-carbonated group, possibly unsaturated or possibly interrupted and/or terminated by at least one heteroatom,
Y, $Y_1$, $Y_2$ and $Y_3$ represent independently a group:
- C(R′) = C(R″) -
- C≡ C -
- N(R′) -
- N=N -
- C(R′)=N -
- N=C(R′) -,
R′ and R″ representing independently -H, alkyl, substituted alkyl, aryl or substituted aryl,
a, b, a′, b′, are numbers equal to 0 or 1,
or where $Y_1$ represents, in addition, a cyclic or heterocyclic arylene group, and in this case b = 1 and a′ = 0,
s and t are whole numbers, including zero, at least one of which is other than zero,
m′ is a whole number at least equal to 1,
the numbers s, t and m′ being such that
$m'(s + t) = m$,
m being a whole number from 4 to 24.

12. Transistor according to the preceding Claim, characterized by the fact that $R'_3$ and/or $R''_3$ represent -H.

13. Use of a transistor as defined in any one of the preceding Claims as a switching or amplifying element.

## Patentansprüche

1. Dünnschicht-Feldeffekttransistor (TFT) mit MIS-Struktur, der zwischen einer Source und einem Drain eine dünne Schicht aus einem Halbleiter aufweist, die mit der einem Fläche einer dünnen Schicht aus einem isolierenden Material und mit der anderen Fläche mit einer leitfähigen Elektrode verbunden ist, wobei der Halbleiter aus mindestens einer Polykonjugierten organischen Verbindung mit definierter Molekülmasse besteht, dadurch gekennzeichnet, daß
die polykonjugierte organische Verbindung bzw. die polykonjugierten organischen Verbindungen mindestens 8 konjugierte Bindungen enthalten und eine Molekülmasse von nicht mehr als etwa 2000 aufweisen und die dünne Schicht aus dem isolierenden Material aus einem isolierenden organischen Polymer hergestellt ist, das eine Dielektrizitätskonstante von mindestens 5 aufweist.

2. Dünnschicht-Feldeffekttransistor nach Anspruch 1, dadurch gekennzeichnet, daß das isolierende Polymer eine Dielektrizitätskonstante von mindestens 6 aufweist.

3. Dünnschicht-Feldeffekttransistor nach einem der vorhergehenden Ansprüche, dadurch gekennzeichnet, daß das isolierende Polymer Polyvinylalkohol ist.

4. Dünnschicht-Feldeffekttransistor nach einem des Ansprüche 1 bis 3, dadurch gekennzeichnet, daß das isolierende Polymer Cyanoethylpullulan ist.

5. Dünnschicht-Feldeffekttransistor nach einem der vorhergehenden Ansprüche, dadurch gekennzeichnet, daß die polykonjugierte Verbindung bzw. die polykonjugierten Verbindungen mindestens 10 konjugierte Bindungen aufweisen.

6. Dünnschicht-Feldeffekttransistor nach einem der vorhergehenden Ansprüche, dadurch gekennzeichnet, daß die polykonjugierte organische Verbindung eine Anzahl an konjugierten Bindungen enthält, die ausreichend ist, daß die Beweglichkeit der Ladungsträger unter der Wirkung eines Feldes mindestens $10^{-3}$ $cm^2V^{-1}s^{-1}$ und insbesondere mindestens $10^{-1}$ $cm^2V^{-1}s^{-1}$ beträgt.

7. Dünnschicht-Feldeffekttransistor nach einem der vorhergehenden Ansprüche, dadurch gekennzeichnet, daß die polykonjugierte organische Verbindung ausgewählt ist unter:
   - konjugierten Oligomeren, deren Einheiten Phenylengruppen enthalten oder aus diesen bestehen, die gegebenenfalls substituiert sind,
   - orthokondensierten oder ortho- und perikondensierten polycyclischen aromatischen Kohlenwasserstoffen, die 4 bis 20 kondensierte Ringe aufweisen,
   - Polyenen der Formel
     $$H-[C(T_1)=C(T_2)]_r-H,$$
     worin $T_1$ und $T_2$ unabhängig -H oder niederes Alkyl bedeuten und r eine ganze Zahl von 8 bis 50 sein kann, und
   - konjugierten Oligomeren, deren wiederkehrende Einheiten mindestens einen fünfgliedrigen Heterocyclus enthalten.

8. Dünnschicht-Feldeffekttransistor nach einem der vorhergehenden Ansprüche, dadurch gekennzeichnet, daß die Oligomeren, die Phenylen-Einheiten enthalten, der Formel I

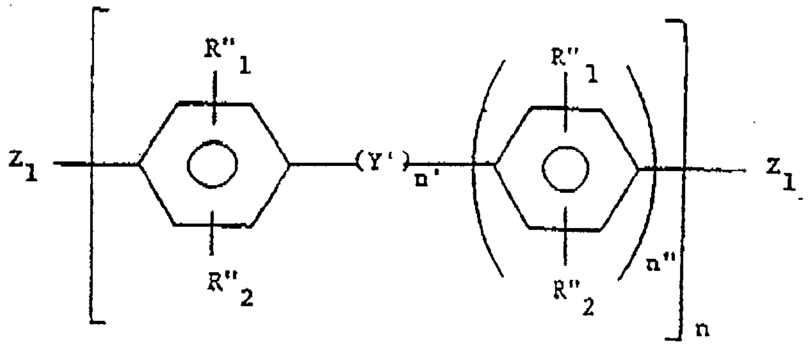

(I)

entsprechen, worin bedeuten:

- $R''_1$, $R''_2$ und $Z_1$ unabhängig -H, Cl, F, Trifluormethyl oder Nitro,
- Y' -$C(T_1)=C(T_2)$-,
  -C≡C-,
  -N(R')-,
  -N=N-,
  -C(R')=N-,
  -N=C(R')-,
  wobei $T_1$ und $T_2$ unabhängig -H oder niederes Alkyl und R' -H, Alkyl, substituiertes Alkyl, Aryl oder substituiertes Aryl darstellen,
- n' die Zahl 0 oder 1,
- n'' die Zahl 0 oder 1 und
- n eine ganze Zahl, die 3 bis 12 betragen kann.

**9.** Dünnschicht-Feldeffekttransistor nach dem vorhergehenden Anspruch, dadurch gekennzeichnet, daß $Z_1$ -H ist.

**10.** Dünnschicht-Feldeffekttransistor nach Anspruch 7, dadurch gekennzeichnet, daß die polycyclische aromatische Verbindung eine orthokondensierte oder ortho- und perikondensierte polycyclische Verbindung der Formel II

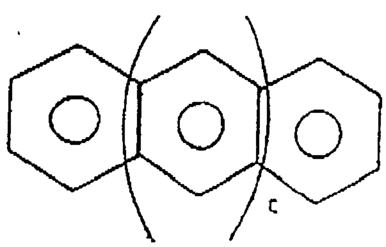

(II)

ist, die also der Summenformel

$$C_{4t+10}H_{2t+8}$$

entspricht, worin t eine ganze Zahl von 2 bis 15 sein kann.

**11.** Dünnschicht-Feldeffekttransistor nach Anspruch 7, dadurch gekennzeichnet, daß das heterocyclische aromatische Oligomer ein Oligomer der Formel III

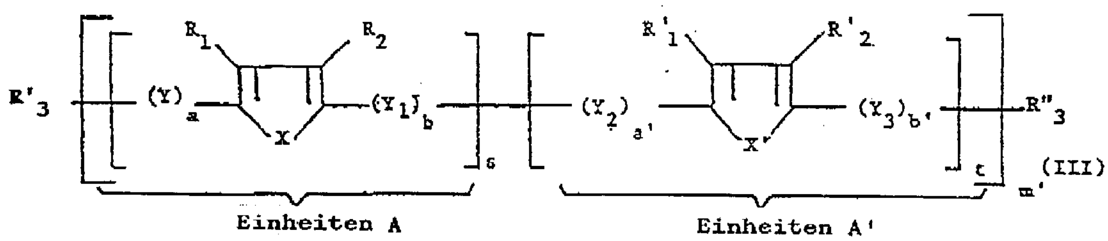

ist, worin bedeuten:

- X und X′ unabhängig O, S, Se, Te oder -N(R)-, worin R H, Alkyl, substituiertes Alkyl, Aryl oder substituiertes Aryl darstellen,
- $R_1$, $R_2$, $R'_1$, $R'_2$, $R'_3$ und $R''_3$ unabhängig -H, Cl, F, $-CF_3$, $-NO_2$, -CN, $-COOR_3$, $-N(R_4)(R_5)$, Alkyl, substituiertes Alkyl, Aryl, substituiertes Aryl, Alkoxy oder Polyalkoxy, worin
  $R_3$ Alkyl oder substituiertes Alkyl oder ein Metall,
  $R_4$ H, Alkyl oder substituiertes Alkyl und
  $R_5$ Alkyl, Acyl oder Aryl darstellen
  oder worin die Paare $R_1$ und $R_2$ und/oder $R'_1$ und $R'_2$ zusammen eine zweiwertige Kohlenwasserstoffgruppe darstellen, die ggfs. ungesättigt oder ggfs. durch mindestens ein Heteroatom unterbrochen ist und/oder mindestens ein endständiges Heteroatom aufweist,
- Y, $Y_1$ $Y_2$ und $Y_3$ unabhängig
  -C(R′)=C(R″)-
  -C≡C-
  -N(R′)-
  -N=N-
  -C(R′)=N-
  -N=C(R′)-,
  wobei R′ und R″ unabhängig -H, Alkyl, substituiertes Alkyl, Aryl oder substituiertes Aryl darstellen
- a, b, a′, b′ die Zahlen 0 oder 1
- und $Y_1$ außerdem eine cyclische oder heterocyclische Arylgruppe, wobei dann b = 1 und a′ = 0 sind,
- s und t ganze Zahlen einschließlich Null, von denen mindestens eine von Null verschieden ist, und
- m′ eine ganze Zahl mindestens gleich 1, wobei die Zahlen s, t und m′ so gewählt sind, daß

$$m'(s+t)=m$$

ist, worin m eine ganze Zahl von 4 bis 24 darstellt.

12. Dünnschicht-Feldeffekttransistor nach dem vorherigen Anspruch, dadurch gekennzeichnet, daß $R'_3$ und/oder $R''_3$ Wasserstoff darstellen.

13. Verwendung des Dünnschicht-Feldeffekttransistors nach einem der vorherigen Ansprüche als Schalt- oder Verstärkerelement.

FIGURE 1